# EUROPÄISCHE PATENTSCHRIFT

(11) **EP 1 830 621 B1**
(45) Veröffentlichungstag und Bekanntmachung des Hinweises auf die Patenterteilung: **20.07.2011**
(21) Anmeldenummer: 07405060.0
(22) Anmeldetag: 27.02.2007
(51) Int. Cl.: H05K 7/12

(54) **Vorrichtung zum Befestigen und Kontaktieren von elektronischen Baugruppen auf Leiterplatten**
Device for securing and connecting electronic modules on circuit boards
Dispositif pour fixer et connecter des modules électroniques sur des plaques de circuits

(30) Priorität: 03.03.2006 CH 3472006
(43) Veröffentlichungstag der Anmeldung: 05.09.2007
(73) Patentinhaber: Landis+Gyr AG, 6300 Zug (CH)
(72) Erfinder: Amstad, Reto, 6343 Rotkreuz (CH)
(74) Vertreter: Rentsch Partner AG

(56) Entgegenhaltungen:
- DE-A1- 3 533 642
- DE-A1- 19 515 073
- US-A1- 2003 173 111
- PATENT ABSTRACTS OF JAPAN Bd. 2003, Nr. 04, 2. April 2003 (2003-04-02) & JP 2002 368513 A (MATSUSHITA ELECTRIC IND CO LTD), 20. Dezember 2002 (2002-12-20)

## Beschreibung

Die Erfindung fällt in das technische Gebiet der elektrischen, bzw. elektronischen Geräte. Sie betrifft eine Anordnung zum Befestigen und Kontaktieren einer elektronischen Baugruppe.

Allgemein bekannt sind Verbindungen zwischen Baugruppen und Leiterplatten, bei denen zumeist Kontaktleisten die elektrische Kontaktierung zueinander herstellen. Hierfür wird beispielsweise eine Baugruppe mit entsprechend ausgebildeten Kontaktzungen unmittelbar in eine Kontaktleiste auf einer Leiterplatte eingeführt, womit alle elektrischen Verbindungen der Baugruppe zu der Leiterplatte in Wirkverbindung treten. Andere Beispiele herkömmlicher Verbindungen zwischen Baugruppen und Leiterplatten sehen eine Flachbandkabelverbindung vor, bei der sowohl die Baugruppe wie die Leiterplatte jeweils Steckerleisten umfassen, die dann über eine Flachbandkabelverbindung zusammengeschlossen werden.

Darüber hinaus bedarf es jedenfalls einer mechanischen, einsatzgerechten Abstützung der Baugruppe gegenüber der Leiterplatte, damit die gesteckten elektrischen Verbindungen frei bleiben von mechanischen Kräften. Herkömmliche Baugruppenverbindungen weisen somit zwei in ihrer Charakteristik verschiedene Kopplungen auf: zum einen die elektrische Verbindung zur Leiterplatte und zum anderen mindestens eine mechanische Halterung, die eine zugehörige Baugruppe gegenüber der Leiterplatte positioniert und fixiert. In der US 2003/173111 A1 ist eine Anordnung zum Befestigen und Kontaktieren einer elektronischen Baugruppe auf einer Leiterplatte mit einer Oberseite und einer Unterseite offenbart, wobei die elektronische Baugruppe einen ersten elektrischen Kontakt aufweist, der mit einem entsprechenden ersten elektrischen Gegenkontakt auf der Oberseite der Leiterplatte eine Wirkverbindung eingeht.

Ausgehend von diesem gattungsbildenden Stand der Technik liegt der vorliegenden Erfindung die Aufgabe zugrunde, eine mechanische und eine elektrische Verbindung zwischen Leiterplatten und zugehörigen Baugruppen zu vereinfachen.

Erfindungsgemäss wird diese Aufgabe durch die Merkmale des Anspruchs 1 gelöst. Die die Erfindung weiterbildenden Merkmale sind Gegenstand der abhängigen Ansprüche 2 bis 11.

Zur Lösung der der Erfindung zugrunde liegenden Aufgabe ist vorgesehen, dass bei einer Vorrichtung zum Befestigen und Kontaktieren einer elektronischen Baugruppe auf einer Leiterplatte die elektronische Baugruppe mindestens einen ersten elektrischen Kontakt aufweist, der mit einem entsprechenden ersten elektrischen Gegenkontakt auf der Oberseite der Leiterplatte eine Wirkverbindung eingeht, wobei mindestens eine Haltevorrichtung vorgesehen ist, mit der die elektronische Baugruppe an der Leiterplatte gehalten ist, und wobei mit der Haltevorrichtung eine elektrische Verbindung zwischen der Leiterplatte und der elektronischen Baugruppe bereitgestellt ist. Somit übt die erfindungsgemässe Haltevorrichtung mit Vorteil eine Doppelfunktion aus, nämlich zum einen die Positionierung und Fixierung der elektronischen Baugruppe in Bezug auf die Leiterplatte und zum anderen die elektrische Kontaktierung zwischen einem elektrischen Anschluss der Baugruppe mit einem elektrischen Anschluss der Leiterplatte.

Eine Ausführungsvariante der Erfindung sieht vor, dass die elektronische Baugruppe eine Oberseite und Unterseite aufweist, wobei die elektronische Baugruppe mit seiner Unterseite an der Haltevorrichtung elektrisch kontaktierbar ist. Vorteilhafterweise ist die Haltevorrichtung als ein mit einer Federwirkung ausgestatteter Haltebügel ausgebildet, dessen Federwirkung die Befestigung und die Kontaktierung zwischen der elektronischen Baugruppe und der Leiterplatte bereitstellt,

Die Haltevorrichtung weist dabei eine erste und eine zweite Ausnehmung auf, mit welchen die Haltevorrichtung eine rastende Wirkverbindung mit der Leiterplatte eingeht. Die Ausnehmungen greifen hierfür an eine Anzahl Rastnocken an, die an der Leiterplatte angeordnet sind. Zudem weisen diese Rastnocken Kontaktflächen auf für die elektrische Verbindung von der Baugruppe über die Haltevorrichtung zur Leiterplatte.

Eine besondere Ausgestaltung der Erfindung sieht vor, dass der erste elektrische Kontakt der elektronischen Baugruppe als ein geschirmter Antennenkontakt ausgebildet ist, wobei der elektrische Kontakt ein zentraler, von einem Schirmkontakt umgebener Stiftkontakt ist. Der mit diesem Stiftkontakt in Verbindung tretende Gegenkontakt auf der Leiterplatte ist mit Vorteil ein Federstiftkontakt, der eine dem Stiftkontakt zugewandte Ausnehmung aufweist, zwecks zentrierender Erfassung des Stiftkontakts beim Kontaktieren.

Eine weitere Ausgestaltung der Erfindung sieht vor, dass die Haltvorrichtung die elektrische Verbindung mit einem Massepotentialanschluss auf der Unterseite der Leiterplatte aufweist. Dies ist besonders vorteilhaft, wenn die elektronische Baugruppe eine weitere Leiterplatte ist, und im Speziellen als ein GSM-Modul ausgebildet ist.

Weitere Vorteile der Erfindung ergeben sich aus den Ansprüchen und der folgenden detaillierte Beschreibung, in der bevorzugte Ausgestaltungen der Erfindung ohne Einschränkung des Erfindungsgedankens und unter Bezugnahme auf die Zeichnung im einzelnen erläutert sind. Dabei zeigt:

Fig. 1 in einer Explosionsdarstellung eine erfindungsgemässe Vorrichtung zur Befestigung und Kontaktierung einer Baugruppe an einer Leiterplatte;

Fig. 2 in einer perspektivischen Ansicht die Vorrichtung in montierter Position, und

Fig. 3 die Vorrichtung in einer weiteren perspektivischen Darstellung.

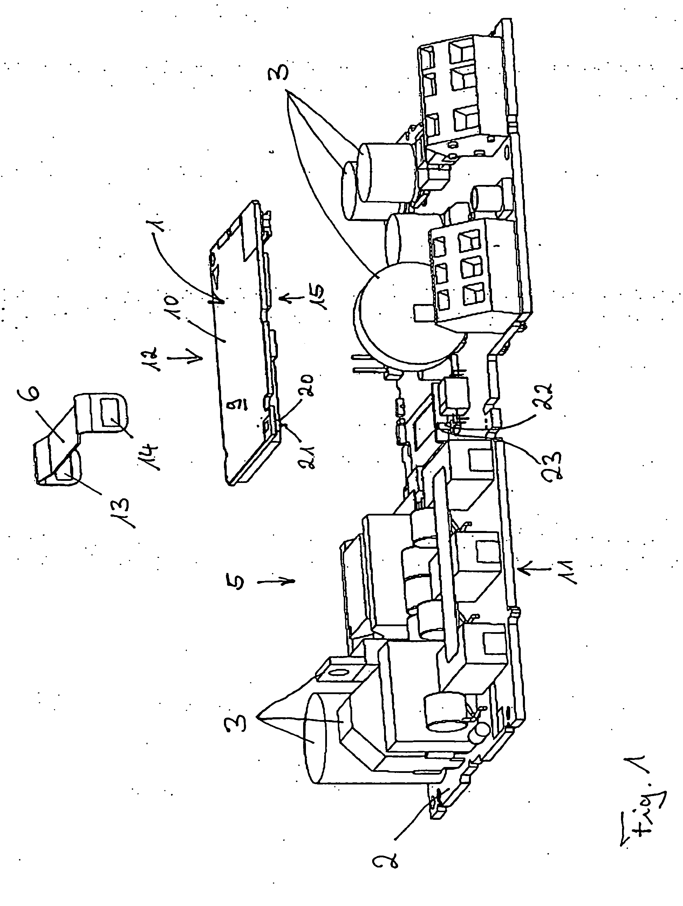

In Fig. 1 ist eine Leiterplatte 2 eines nicht näher spezifizierten elektrischen/elektronischen Geräts gezeigt mit einer Oberseite 5 und einer Unterseite 11. Die Leiterplatte 2 ist mit Bauelementen 3 auf ihrer Oberseite 5 bestückt. In explosionsartiger Darstellung sind zur Oberseite 5 der Leiterplatte 2 hin eine elektrische/elektronische Baugruppe 1 und eine Haltevorrichtung 6 angeordnet. Die Baugruppe 1 besteht hier beispielhaft aus einer weiteren Leiterplatte 10 mit einer Oberseite 4 und einer Unterseite 12. Auf ihrer Unterseite 12 weist die weitere Leiterplatte 10 einen Massepotentialanschluss 9 auf und auf ihrer Oberseite 4 hier nicht gezeigte Bauelemente.

Mit 21 ist ein elektrischer Kontakt an der weiteren Leiterplatte 10 bezeichnet, der im montierten Zustand mit einem elektrischen Gegenkontakt 22 der Leiterplatte 2 verbunden ist. Da der elektrische Kontakt 21 - als Stiftkontakt ausgebildet - in der hier ausgestalteten Form ein Koaxialanschluss ist, ist er umgeben von einer Schirmung 20. Der Gegenkontakt 22 ist als Federstiftkontakt ausgebildet und weist an seiner dem Stiftkontakt 21 zugewandten Seite eine Ausnehmung 23 auf, zwecks zentrierendem Positionieren dieses Stiftkontakts 21 mit diesem Federstiftkontakt 22.

Die Haltevorrichtung 6 ist ein mit einer Federwirkung ausgestatteter Haltebügel, dessen Federwirkung die Befestigung und die Kontaktierung zwischen der weiteren Leiterplatte 10 und der Leiterplatte 2 bereitstellt. Zur einrastenden Halterung der Haltevorrichtung 6 an der Leiterplatte 2 weist die Haltevorrichtung 6 eine erste und zweite Ausnehmung 13, 14 auf.

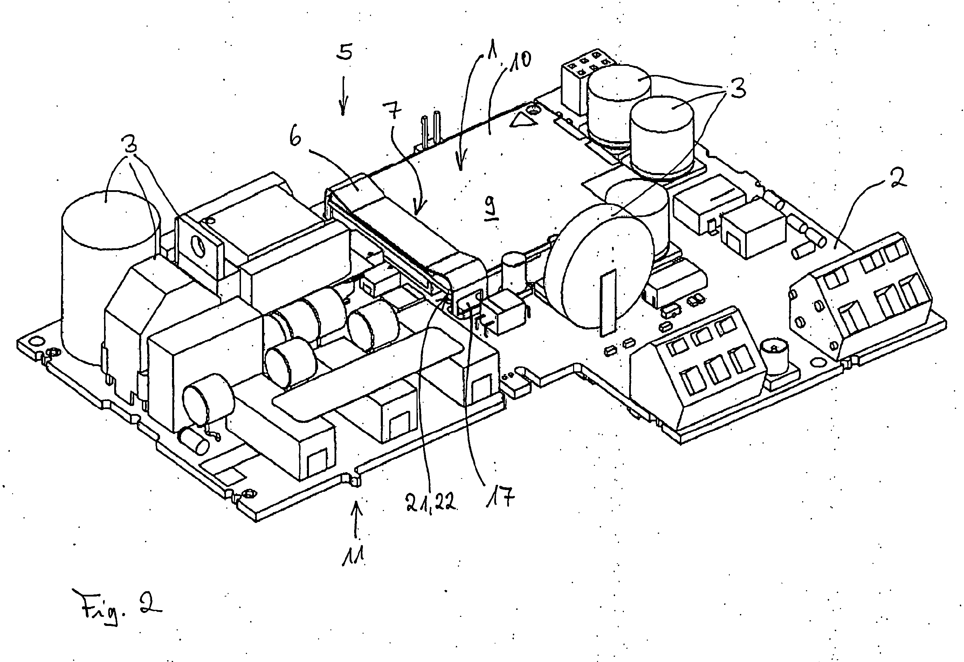

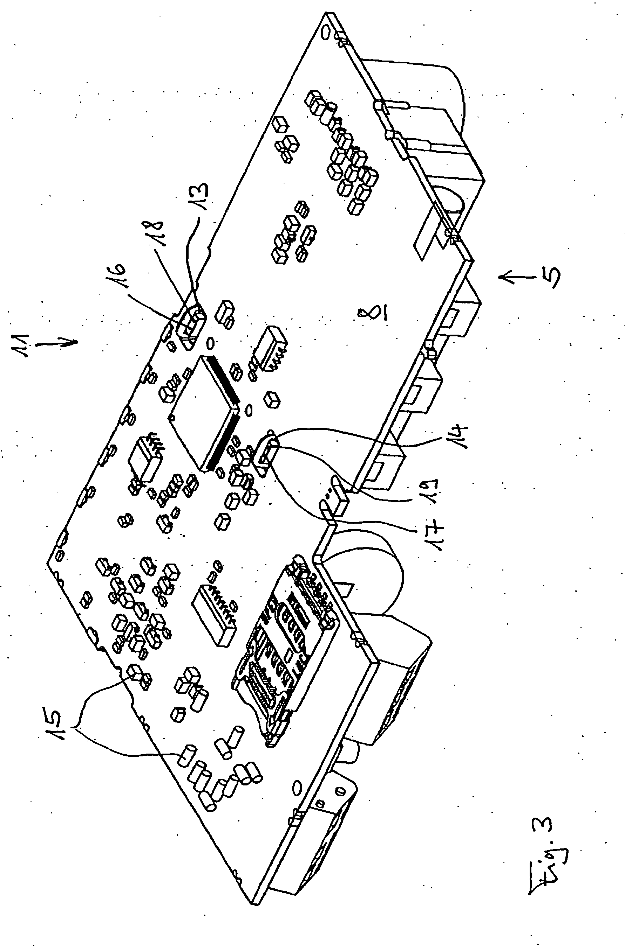

Fig. 2 zeigt die weitere Leiterplatte 10 in montierter Betriebsposition an der Leiterplatte 2. Für die einrastende Halterung der Haltevorrichtung 6 an der Leiterplatte 2, sind an ihr eine erste entsprechende Nocke 17 und eine hier nicht sichtbare zweite Nocke 16 angeordnet (siehe auch die folgende Beschreibung zu Fig. 3). Die Haltevorrichtung 6 ist aus einem elektrische leitfähigen Material hergestellt und geht mit der weiteren Leiterplatte 10 an deren Massepotentialanschluss 9 eine entsprechende elektrische Verbindung 7 ein.

In perspektivischer Darstellung zeigt die Fig. 3 die Unterseite 11 der Leiterplatte 2, die ebenfalls mit Bauelementen 15 bestückt ist. Hier sichtbar, umfasst die Leiterplatte 2 zwei Nocken 16, 17, an welchen die Ausnehmungen 13 und 14 der Haltevorrichtung 6 rastend angreifen. Die Leiterplatte 2 weist auf ihrer Unterseite 11 an ihren Nocken 16, 17 eine erste und eine zweite Kontaktfläche 18, 19 auf, die elektrisch mit einem Massepotentialanschluss 8 der Leiterplatte verbunden sind. Mittels dieser Kontaktflächen 18, 19 verbindet die Haltevorrichtung 6 den Massepotentialanschluss 9 der weiteren Leiterplatte 10 mit dem Massepotentialanschluss 8 der Leiterplatte 2.

### Bezugszeichenliste

- 1: elektronische Baugruppe
- 2: Leiterplatte
- 3: Bauelemente
- 4: Oberseite der elektronischen Baugruppe 1, bzw. der weiteren Leiterplatte 10
- 5: Oberseite der Leiterplatte 2
- 6: Haltevorrichtung
- 7: elektrische Verbindung
- 8: Massepotentialanschluss der Leiterplatte 2
- 9: Massepotentialanschluss der elektronischen Baueinheit 1
- 10: weitere Leiterplatte
- 11: Unterseite der Leiterplatte 2
- 12: Unterseite der weiteren Leiterplatte 10
- 13: Ausnehmung in 6
- 14: Ausnehmung in 6
- 15: Bauelemente
- 16: Nocke an Leiterplatte 2
- 17: Nocke an Leiterplatte 2
- 18: Kontaktfläche
- 19: Kontaktfläche
- 20: Schirmung
- 21: elektrischer Kontakt, Stiftkontakt
- 22: elektrischer Gegenkontakt, Federstiftkontakt
- 23: Ausnehmung im Federstiftkontakt 22

## Patentansprüche

1. Anordnung einer elektronischen Baugruppe (1) auf einer Leiterplatte (2) mit einer Oberseite (5) und einer Unterseite (11) und mit einer Haltevorrichtung (6) zum Befestigen und Kontaktieren der elektronischen Baugruppe (1) auf der Oberseite (5), wobei die elektronische Baugruppe (1) mindestens einen ersten elektrischen Kontakt (21) aufweist, der mit einem entsprechenden ersten elektrischen Gegenkontakt (22) auf der Oberseite (5) der Leiterplatte (2) eine Wirkverbindung eingeht und wobei mit der mindestens einen Haltevorrichtung (6) die elektronische Baugruppe (1) an der Leiterplatte (2) gehalten ist, wobei mit der Haltevorrichtung (6) eine elektrische Verbindung zwischen der Leiterplatte (2) und der elektronischen Baugruppe (1) bereitgestellt ist, **dadurch gekennzeichnet, dass** die elektronische Baugruppe (1) eine weitere Leiterplatte (10) ist, wobei diese weitere leiterplatte (10) als ein GSM-Modul ausgebildet ist, und dass die Haltvorrichtung (6) die elektrische Verbindung mit einem Massepotentialanschluss (8) auf der Unterseite (11) der Leitplatte (2) aufweist.

2. Anordnung nach Anspruch 1, **dadurch gekennzeichnet, dass** die elektronische Baugruppe (1) eine Oberseite (4) und Unterseite (12) aufweist, wobei die elektronische Baugruppe (1) mit ihrer Unterseite (12) an der Haltevorrichtung (6) elektrisch kontaktierbar ist.

3. Anordnung nach einem der Ansprüche 1 oder 2, **dadurch gekennzeichnet, dass** die Haltevorrichtung (6) als ein mit einer Federwirkung ausgestatteter Haltebügel ist, dessen Federwirkung die Befestigung und die Kontaktierung zwischen der elektronischen Baugruppe (1) und der Leiterplatte (2) bereitstellt.

4. Anordnung nach einem der Ansprüche 1 bis 3, **dadurch gekennzeichnet, dass** die Haltevorrichtung (6) eine erste und eine zweite Ausnehmung (13, 14) aufweist, mit welchen Ausnehmungen (13, 14) die Haltevorrichtung (6) eine rastende Wirkverbindung mit der Leiterplatte (2) aufweist.

5. Anordnung nach einem der vorhergehenden Ansprüche 1 bis 4, **dadurch gekennzeichnet, dass** die Leiterplatte (2) eine Anzahl Nocken (16, 17) aufweist, die auf der Unterseite (11) der Leiterplatte (2) eine Anzahl Kontaktflächen (18, 19) für eine elektrische Verbindung mit der Haltevorrichtung (6) aufweisen.

6. Anordnung nach einem der Ansprüche 1 bis 5, **dadurch gekennzeichnet, dass** der erste elektrische Kontakt (21) der elektronischen Baugruppe (1) als ein geschirmter Antennenkontakt ausgebildet ist, wobei der elektrische Kontakt (21) ein zentraler, von einem Schirmkontakt (20) umgebener Stiftkontakt (21) ist.

7. Anordnung nach einem der Ansprüche 1 bis 6, **dadurch gekennzeichnet, dass** der Gegenkontak auf der Leiterplatte (2) als ein Federstiftkontakt (22) ausgebildet ist

8. Anordnung nach Anspruch 7, **dadurch gekennzeichnet, dass** der Federstiftkontakt (22) an einer dem Stiftkontakt (21) zugewandten Seite eine Ausnehmung (23) aufweist, zwecks zentrierendem Positionieren des Stiftkontakts (21) beim Kontaktieren.

## Claims

1. Arrangement of an electronic assembly (1) on a circuit board (2) having a top side (5) and an underside (11) and having a holding device (6) for fixing and contact-connecting the electronic assembly (1) on the top side (5), wherein the electronic assembly (1) has at least one first electrical contact (21) which establishes an operative connection together with a corresponding first electrical mating contact (22) on the top side (5) of the circuit board (2), and wherein the electronic assembly (1) is held on the circuit board (2) by the at least one holding device (6), wherein an electrical connection between the circuit board (2) and the electronic assembly (1) is provided by the holding device (6), **characterized in that** the electronic assembly (1) is a further circuit board (10), wherein said further circuit board (10) is embodied as a GSM module, and **in that** the holding device (6) has the electrical connection to an earth potential terminal (8) on the underside (11) of the circuit board (2).

2. Arrangement according to Claim 1, **characterized in that** the electronic assembly (1) has a top side (4) and an underside (12), wherein the electronic assembly (1) can be electrically contact-connected by its underside (12) at the holding device (6).

3. Arrangement according to either of Claims 1 and 2 **characterized in that** the holding device (6) is embodied as a holding clip which is equipped with a spring action and the spring action of which provides the fixing and the contact-connection between the electronic assembly (1) and the circuit board (2).

4. Arrangement according to any of Claims 1 to 3, **characterized in that** the holding device (6) has a first and a second cutout (13, 14), with which cutouts (13, 14) the holding device (6) has a latching operative connection to the circuit board (2).

5. Arrangement according to any of the preceding claims 1 to 4, **characterized in that** the circuit board (2) has a number of cams (16, 17) which have, on the underside (11) of the circuit board (2), a number of contact areas (18, 19) for an electrical connection to the holding device (6).

6. Arrangement according to any of Claims 1 to 5, **characterized in that** the first electrical contact (21) of the electronic assembly (1) is embodied as a screened antenna contact, wherein the electrical contact (21) is a central pin contact (21) surrounded by a screen contact (20).

7. Arrangement according to any of Claims 1 to 6, **characterized in that** the mating contact on the circuit board (2) is embodied as a spring pin contact (22).

8. Arrangement according to Claim 7, **characterized in that** the spring pin contact (22) has a cutout (23) on a side facing the pin contact (21), for the purpose of centring positioning of the pin contact (21) during contact-connection.

## Revendications

1. Arrangement d'un sous-ensemble électronique (1) sur un circuit imprimé (2) comprenant un dessus (5) et un dessous (11) et comprenant un dispositif de maintien (6) pour fixer et mettre en contact le sous-ensemble électronique (1) sur le dessus (5), le sous-ensemble électronique (1) présentant au moins un premier contact électrique (21) qui entre dans une liaison active avec un premier contact homologue électrique (22) correspondant sur le dessus (5) du circuit imprimé (2) et le sous-ensemble électronique (1) étant maintenu sur le circuit imprimé (2) avec l'au moins un dispositif de maintien (6), une liaison électrique entre le circuit imprimé (2) et le sous-ensemble électronique (1) étant mise à disposition avec le dispositif de maintien (6), **caractérisé en ce que** le sous-ensemble électronique (1) est un autre circuit imprimé (10), cet autre circuit imprimé (10) étant réalisé sous la forme d'un module GSM et **en ce que** le dispositif de maintien (6) présente la liaison électrique avec une borne de potentiel de masse (8) sur le dessous (11) du circuit imprimé (2).

2. Arrangement selon la revendication 1, **caractérisé en ce que** le sous-ensemble électronique (1) présente un dessus (4) et un dessous (12), le sous-ensemble électronique (1) pouvant être mis en contact électrique par son dessous (12) avec le dispositif de maintien (6).

3. Arrangement selon l'une des revendications 1 ou 2, **caractérisé en ce que** le dispositif de maintien (6) est un étrier de maintien doté d'un effet de ressort dont l'effet de ressort réalise la fixation et la mise en contact entre le sous-ensemble électronique (1) et le circuit imprimé (2).

4. Arrangement selon l'une des revendications 1 à 3, **caractérisé en ce que** le dispositif de maintien (6) présente un premier et un deuxième évidement (13, 14), évidements (13, 14) avec lesquels le dispositif de maintien (6) présente une liaison active par enclenchement avec le circuit imprimé (2).

5. Arrangement selon l'une des revendications précédentes 1 à 4, **caractérisé en ce que** le circuit imprimé (2) présente une pluralité de cames (16, 17) qui présentent sur le dessous (11) du circuit imprimé (2) une pluralité de surfaces de contact (18, 19) pour une liaison électrique avec le dispositif de maintien (6).

6. Arrangement selon l'une des revendications 1 à 5, **caractérisé en ce que** le premier contact électrique (21) du sous-ensemble électronique (1) est réalisé sous la forme d'un contact d'antenne blindé, le contact électrique (21) étant un contact en broche (21) central entouré par un contact de blindage (20).

7. Arrangement selon l'une des revendications 1 à 6, **caractérisé en ce que** le contact homologue sur le circuit imprimé (2) est réalisé sous la forme d'un contact en broche à ressort (22).

8. Arrangement selon la revendication 7, **caractérisé en ce que** le contact en broche à ressort (22) présente sur un côté faisant face au contact en broche (21) un évidement (23) dans le but d'obtenir un positionnement centré du contact en broche (21) lors de la mise en contact.
